# EUROPEAN PATENT SPECIFICATION

(11) **EP 3 657 067 B1**
(45) Date of publication and mention of the grant of the patent: **18.08.2021**
(21) Application number: 18382847.4
(22) Date of filing: 23.11.2018
(51) Int. Cl.: F21S 41/19, F21S 41/147, F21S 45/47, F21S 41/151, F21S 41/155, H05K 3/00, F21V 29/89, F21V 29/70, F21Y 107/50, H05K 1/18, H05K 1/02

(54) **AUTOMOTIVE LIGHTING DEVICE AND METHOD FOR MANUFACTURING AN AUTOMOTIVE LIGHTING DEVICE**
AUTOMOBILBELEUCHTUNGSVORRICHTUNG UND VERFAHREN ZUR HERSTELLUNG EINER AUTOMOBILBELEUCHTUNGSVORRICHTUNG
DISPOSITIF D'ÉCLAIRAGE AUTOMOBILE ET SON PROCÉDÉ DE FABRICATION D'UN DISPOSITIF D'ÉCLAIRAGE AUTOMOBILE

(43) Date of publication of application: 27.05.2020
(73) Proprietor: VALEO ILUMINACION, S.A., 23600 Martos (ES)
(72) Inventor: LOBATO, Miguel-Angel, 23600 Martos (ES); ANDRES, Alvaro, 23600 Martos (ES); SANCHEZ, Alfredo-Antonio, 23600 Martos (ES)
(74) Representative: Valeo Visibility

(56) References cited:
- EP-A1- 3 190 334
- EP-A1- 3 211 294
- EP-A2- 2 357 398
- FR-A1- 3 056 678
- JP-A- 2010 146 817
- US-A1- 2017 219 202
- US-A1- 2018 209 604

## Description

### TECHNICAL FIELD

This invention is related to the field of lighting devices comprised in automotive lighting devices, and more particularly, with their heat sink arrangement.

### STATE OF THE ART

Current lighting devices require a good heat dissipation, since the light sources used therein are very powerful but very sensitive to their working temperature.

Metallic heat sinks are used to dissipate the heat produced in the light sources. However, the thermal design is important, since just placing a heat sink is not enough. The heat must find a way to be dissipated, and a proper exchange surface must be provided.

Further, the light sources may be placed in different positions. When two or more lighting functionalities are required in a lighting device, the different lighting functionalities may be arranged in different relative positions with respect to each other.

One option is placing all the lighting functionalities in the same plane, emitting light according to the same direction. This is easy for manufacturing, since a plane metallic heat sink may be provided to fulfill the dissipation requirements of the lighting sources involved.

However, in different applications, different functionalities may be provided in different planes, which are not parallel. Further, these may be offset, so that the distance between the planes and the orientation may not be chosen, since they are fixed by light design parameters.

When trying to provide a heat sink for different functionalities which are located in different planes, the resulting metallic plate may be difficult to be manufactured, due to the acute angles that result when the single plate tries to meet the two functionalities.

Known lighting devices are disclosed in US 2018/209604 A1 and EP 2 357 398 A2.

### DESCRIPTION OF THE INVENTION

The invention provides an alternative solution for providing a heat sink to two different functionalities by an automotive lighting device according to claim 1 and a method for manufacturing an automotive lighting device according to claim 9. Preferred embodiments of the invention are defined in dependent claims.

Unless otherwise defined, all terms (including technical and scientific terms) used herein are to be interpreted as is customary in the art. It will be further understood that terms in common usage should also be interpreted as is customary in the relevant art and not in an idealised or overly formal sense unless expressly so defined herein.

In this text, the term "comprises" and its derivations (such as "comprising", etc.) should not be understood in an excluding sense, that is, these terms should not be interpreted as excluding the possibility that what is described and defined may include further elements, steps, etc.

In a first inventive aspect, the invention provides an automotive lighting device according to claim 1.

The heat sink is a continuous piece which has a cut, so that, when the heat sink is bent, part of the heat sink is not bent and therefore protrudes from the continuous profile. This portion which protrudes is used as a heat dissipation surface for the first light element. In other embodiments, this portion is used for the second light element, or in further embodiments, there are more than one protruding portion, one for each light element.

The shape of the heat sink is such that the plane portions which are used as heat dissipation surfaces for each light element cut in a line which defines two semiplanes: one semiplane containing the first light element and other semiplane which contains the second light element. These semiplanes form an acute angle, so it would require the heat sink to be manufactured with an acute angle to fit with a continuous shape both plane portions.

The connecting arms are just part of the heat sink, since the protruding portion stands out from the connecting arms and the connecting arms are connecting the first plane portion with the second plane portion. However, the shape of the connecting arms is more favourable to be manufactured, since the curve defined by the connecting arms has no acute angles, and the tangent varies in a soft way, always with a variation lower than 90 degrees between two different points of the connecting arms. Even in some embodiments, this variation is lower than 60 degrees.

As a consequence, a heat sink is provided for two different light functionalities which are placed in converging planes.

In some particular embodiments, the light element is a solid-state light source which is directly mounted on the heat sink. In other particular embodiments, the light element is a printed circuit board which contains solid-state light sources.

These options refer to the different ways the functionalities may be mounted on the heat sink, either by a direct submount or by means of a printed circuit board.

The term "solid state" refers to light emitted by solid-state electroluminescence, which uses semiconductors to convert electricity into light. Compared to incandescent lighting, solid state lighting creates visible light with reduced heat generation and less energy dissipation. The typically small mass of a solid-state electronic lighting device provides for greater resistance to shock and vibration compared to brittle glass tubes/bulbs and long, thin filament wires. They also eliminate filament evaporation, potentially increasing the life span of the illumination device. Some examples of these types of lighting comprise semiconductor light-emitting diodes (LEDs), organic light-emitting diodes (OLED), or polymer light-emitting diodes (PLED) as sources of illumination rather than electrical filaments, plasma or gas.

This automotive lighting device comprises a plurality of solid-state light sources which are in charge of providing different functionalities. As solid-state light sources, the heat dissipation requirements is very important.

In some particular embodiments, the automotive lighting device further comprises additional heat dissipation means in thermal contact with the heat sink.

These additional heat dissipation means contribute with the main heat sink to communicate the heat emitted by the light sources to the ambient air surrounding the lighting device.

In some particular embodiments, the additional heat dissipation means comprise fins and/or pins.

Fins and pins are heat dissipation elements which advantageously cooperate with the main heat sink to dissipate the heat emitted by the light sources.

In some particular embodiments, the additional heat dissipation means are clamped to the heat sink.

Since the heat sink requires a forming process so that the protruding portion is made to protrude from the rest of the heat sink, the additional heat dissipation means may be added in a further step, e.g., by clamping or any other suitable operation. Clamping ensures a good connection and may be performed easily after the heat sink forming process.

In some particular embodiments, the heat sink plate comprises a bended portion which form the additional heat dissipation means.

A bended portion is a way of providing additional heat dissipation means, which may be easily formed during the forming process of the heat sink.

In some particular embodiments, the automotive lighting device further comprises an optical element intended to receive light from the first and second light source elements, and project the light outside the automotive lighting device, this optical element being, for example, a projecting lens.

In a second inventive aspect, the invention provides a method for manufacturing a lighting device according to claim 10.

With this method, the manufactured lighting device comprises at least two different functionalities which are properly cooled, by two portions of the heat sink. This manufacturing method is easy to reproduce at a not very high cost.

In some particular embodiments, the method further comprises the steps of adding additional heat dissipation means.

These additional heat dissipation means contribute with the main heat sink to communicate the heat emitted by the light sources to the ambient air surrounding the lighting device.

In some particular embodiments, the additional heat dissipation means are added to the heat sink plate by clamping or by fixing.

Clamping and fixing are steps which may be integrated in the manufacturing process of the heat sink plate.

In some particular embodiments, the additional heat dissipation means are added to the heat sink by bending at least one end of the heat sink plate.

A bended portion is a way of providing additional heat dissipation means, which may be easily formed during the forming process of the heat sink.

In some particular embodiments, the heat sink plate is formed by cool stamping, the bending being carried out by stamping.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figure 1 shows some elements of an automotive lighting device according to the invention.
Figure 2 shows a side view of a heat sink of an embodiment of lighting device according to the invention.
Figure 3 shows a side view of a heat sink of an embodiment of lighting device according to the invention.
Figures 4a and 4b show rear views of heat sinks of different embodiments of lighting device according to the invention.
Figures 5a to 5e show steps of manufacturing of some elements of the automotive lighting device according to the invention.
Figure 6 shows an automotive vehicle with an automotive lighting device according to the invention.

### DETAILED DESCRIPTION OF THE INVENTION

The example embodiments are described in sufficient detail to enable those of ordinary skill in the art to embody and implement the systems and processes herein described. It is important to understand that embodiments can be provided in many alternate forms and should not be construed as limited to the examples set forth herein.

Accordingly, while embodiment can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

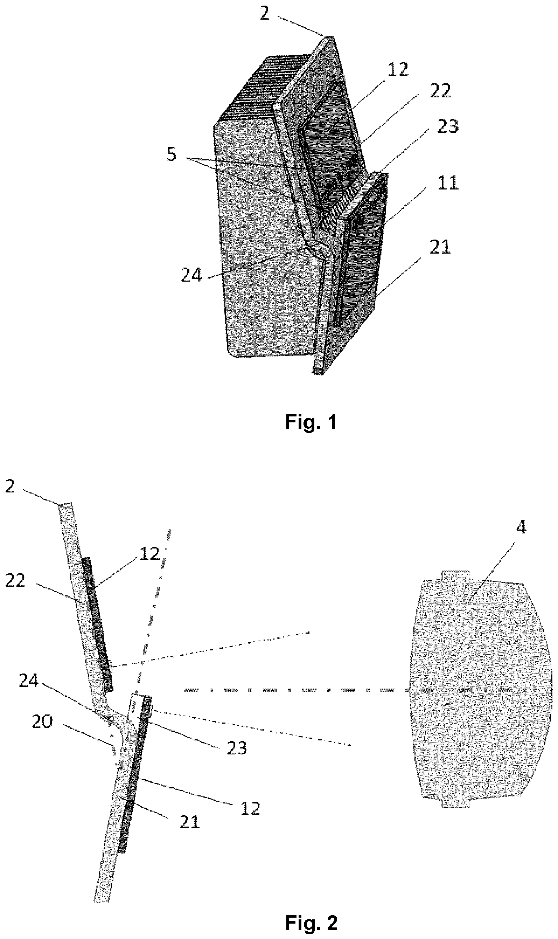

Figure 1 shows some elements of an automotive lighting device 1 according to the invention. One of these elements is a main heat sink 2 with a first plane portion 21 and a second plane portion 22.

This lighting device 1 also comprises two printed circuit boards, a first printed circuit board 11 comprising LEDs 5 intended to provide a high beam functionality and a second printed circuit board 12 comprising LEDs 5 intended to provide a low beam functionality. The first printed circuit board 11 is arranged in direct contact with the first plane portion 21 of the heat sink 2 and the second printed circuit board 12 is arranged in direct contact with the second plane portion 22.

However, in other embodiments, instead of printed circuit boards, there are groups of LEDs directly mounted on the heat sink, each group of LEDs being intended to perform one of the lighting functionalities.

In this figure, it may be seen how a protruding portion 23 of the first plane portion 21 protrudes from the heat sink 2. This protruding portion 23 protrudes to give a heat dissipation support for the first printed circuit board 11. The rest of the first plane portion continues in the shape of connecting arms 24 to reach the second plane portion 22, thus providing continuity between the first plane portion 21 and the second plane portion 22.

Figure 2 shows a side view of the heat sink 2 and the elements associated thereto.

As may be seen in this figure, the first printed circuit board 11 is arranged to provide a high beam in a first light direction and the second printed circuit board 12 is arranged to provide a low beam in a second light direction which forms 20 degrees with respect to the first light direction. These beams are directed to a projecting lens 4.

The second plane portion 22, which provides support to the second printed circuit board 12, is contained in a second plane 20 which cuts the first plane portion 21 in such a way that the second plane 20 and the portion of the first plane portion 21 which is in direct contact with the first printed circuit board 11 form an acute angle. As a consequence, if the two printed circuit boards were met by a heat sink with no protruding portions, the heat sink would have to meet this acute angle, which would lead to manufacturing problems. The protruding portion 23 prevents the heat sink 2 to have this acute angle.

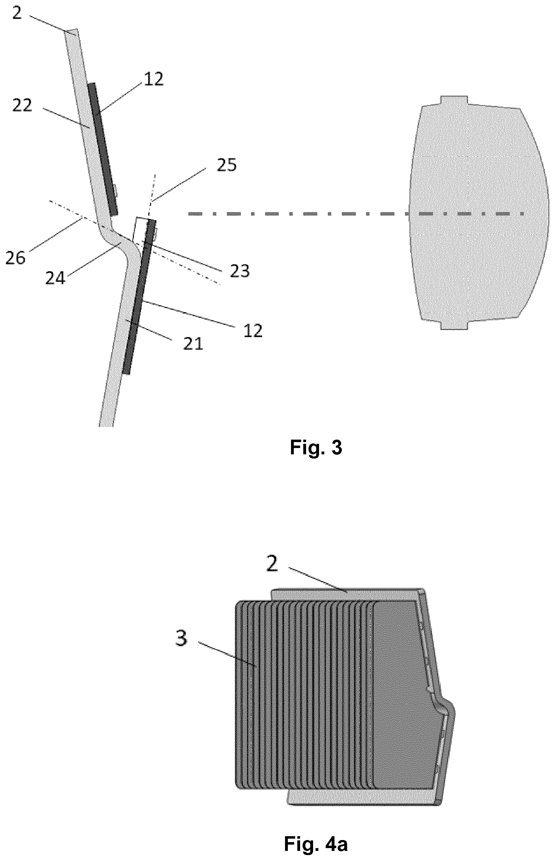

The shape of the connecting arms 24 is therefore independent of this acute angle, since the position of the first printed circuit board 11 is not met by the connecting arms 24, but by the protruding portion 23. As a consequence, the connecting arms 24 may be manufactured with a soft angle variation, such as the one shown in figure 3. As may be seen, the difference between a first tangent line 25 which is tangent to the curve in any first point and a second tangent line 26 which is tangent to the curve in any second point is lower than 90 degrees. This ensures a smooth manufacturing process with no risk of cracks being formed. Further, since the shape of the connecting arms 24 is independent of the angle formed between the first and second portions, the connecting arms 24 may have an even smoother angle variation, such as for example 60 degrees.

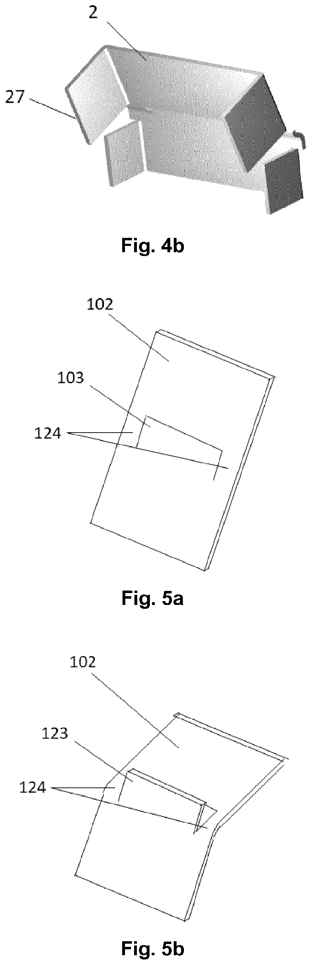

Figures 4a and 4b show rear views of this heat sink 2 with two different options of additional heat dissipation means.

Figure 4a shows a plurality of fins 3 which are attached to the heat sink 2 in order to cooperate with it in the dissipation of the heat emitted by the LEDs of the printed circuit boards. In different embodiments, instead of fins, some pins may be installed, to perform the same function.

Figure 4b shows an extended heat sink 2, wherein the ends 27 thereof are bent to form structures which are similar to fins, thus providing additional heat dissipation means.

Figures 5a to 5e show steps of manufacturing some elements of the automotive lighting device according to the invention

Figure 5a shows the provision of a heat sink plate 102 wherein one cut 103 is performed. As a consequence of this cut, two connecting arms 124 are defined.

Figure 5b represents a bending operation in the connecting arms 124, so that a first protruding portion 123, which resulted from the cut performed in the previous step, is not bended and protrudes from the heat sink plate 102.

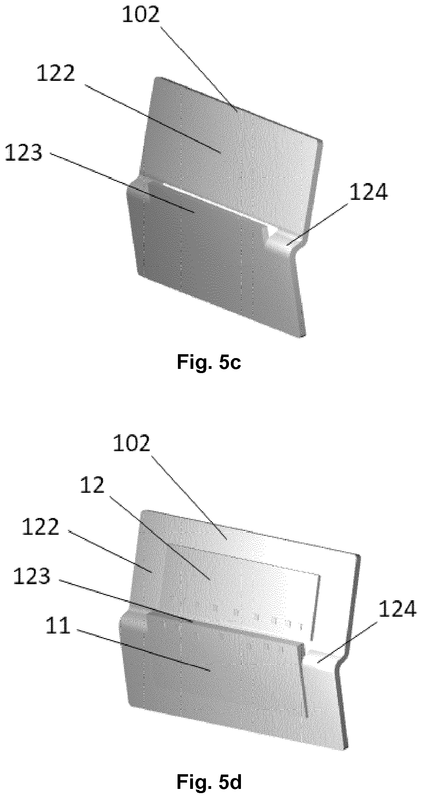

Figure 5c shows a second bending operation in the connecting arms 124, to form a second portion 122 of the heat sink plate 102. This second portion 122 forms 20 degrees with respect to the first protruding portion 123.

Figure 5d represents the installation of a first printed circuit board 11 in the first protruding portion 123 of the heat sink 102 and a second printed circuit board 12 in the second portion 122 of the heat sink 102.

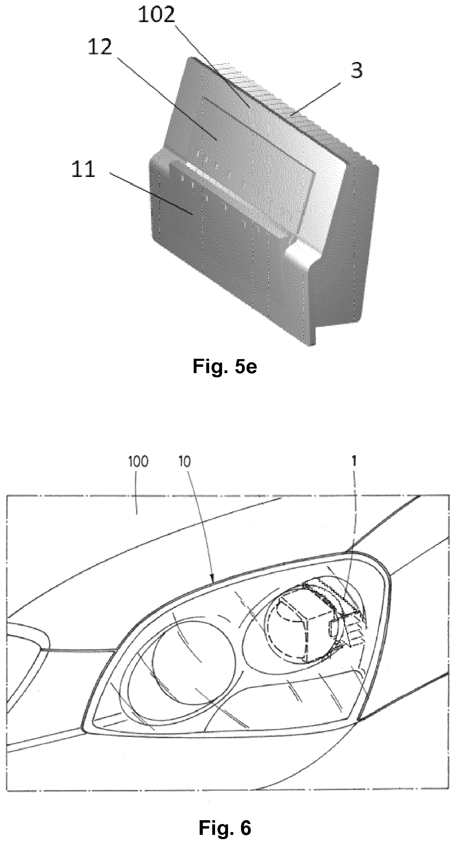

Figure 5e shows a further step of this method, where some fins 3 are clamped to the heat sink 102, to provide further heat dissipation means which collaborate with the heat sink 102 in dissipating the heat that is going to be generated in the first and second printed circuit boards 11, 12.

Figure 6 shows an automotive vehicle 100 which comprises an automotive lighting device 1 as described in any of the previous figures.

The automotive lighting device 1 further comprises a lens 4 which is arranged to receive light from the LEDs of the first and second printed circuit board, and project the light outside the automotive lighting device 1.

## Claims

1. Automotive lighting device (1) comprising at least
a first light element (11) for a first lighting functionality and a second light element (12) for a second lighting functionality, the first light element (11) being arranged to provide a light beam in a first light direction and the second light element (12) being arranged to provide a light beam in a second light direction;
a heat sink (2) comprising a bent heat sink plate (102), said heat sink plate (102) having a first plane portion (21) and a second plane portion (22), wherein the first light element (11) is arranged in direct contact with the first plane portion (21) and the second light element (12) is arranged in direct contact with the second plane portion (22),
**characterized in that**:
- the second light direction forms at least 20 degrees with respect to the first light direction;
- the second plane portion (22) is contained in a second plane (20) which cuts the first plane portion (21) in such a way that the second plane (20) and the portion of the first plane portion (21) which is in direct contact with the first light element (11) form an acute angle;
- a protruding portion (23) of the first plane portion (21) and/or a protruding portion of the second plane portion (22) protrudes from the heat sink (2) in such a way that the heat sink comprises connecting arms (24) in direct contact with the first plane portion (21) and with the second plane portion (22), and
- each one of the connecting arms (24) define a curve and the difference between a first tangent line (25) which is tangent to the curve in any first point and a second tangent line (26) which is tangent to the curve in any second point is lower than 90 degrees.

2. Automotive lighting device (1) according to claim 1, wherein the light element is a solid-state light source which is directly mounted on the heat sink.

3. Automotive lighting device (1) according to claim 1, wherein the light element is a printed circuit board which contains solid-state light sources.

4. Automotive lighting device (1) according to any of the preceding claims, wherein the difference between a first tangent line (25) which is tangent to the curve in any first point and a second tangent line (26) which is tangent to the curve in any second point is lower than 60 degrees.

5. Automotive lighting device (1) according to any of the preceding claims, further comprising additional heat dissipation means in thermal contact with the heat sink (2).

6. Automotive lighting device (1) according to claim 5, wherein the additional heat dissipation means comprise fins (3) and/or pins.

7. Automotive lighting device (1) according to any of claims 5 or 6, wherein the additional heat dissipation means are clamped to the heat sink (2).

8. Automotive lighting device (1) according to claim 5, wherein the heat sink plate (102) comprises a bended portion (27) which forms the additional heat dissipation means.

9. Automotive lighting device (1) according to any of the preceding claims, further comprising an optical element (4) intended to receive light from the first (11) and second (12) light source elements, and project the light outside the automotive lighting device (1), this optical element being, for example, a projecting lens (4).

10. Method for manufacturing a lighting device (1) according to any of the preceding claims,
**characterized in that** the method comprises the steps of
providing a heat sink plate (102) performing at least one cut (103) in the heat sink plate (102), the cut defining two connecting arms (24, 124), one connecting arm at each side of a first portion of the heat sink plate;
bending the connecting arms so that the first portion (21) is not bended and protrudes from the heat sink plate;
bending the connecting arms again with a second portion (22) of the heat sink plate, so that the second portion forms at least 20 degrees with respect to the first portion installing a first light source element (11) in the first portion of the heat sink and a second light source element (12) in the second portion of the heat sink.

11. Method according to claim 10, further comprising the steps of adding additional heat dissipation means (3, 27).

12. Method according to claim 11, wherein the additional heat dissipation means are added to the heat sink plate by clamping or by fixing.

13. Method according to claim 11, wherein the additional heat dissipation means (27) are added to the heat sink by bending at least one end of the heat sink plate.

14. Method according to any of claims 10 to 13, wherein the heat sink plate (102) is formed by cool stamping, the bending being carried out by stamping.

## Patentansprüche

1. Automobilbeleuchtungsvorrichtung (1), mindestens umfassend:
ein erstes Leuchtelement (11) für eine erste Beleuchtungsfunktionalität und ein zweites Leuchtelement (12) für eine zweite Beleuchtungsfunktionalität, wobei das erste Leuchtelement (11) dazu angeordnet ist, einen Lichtstrahl in einer ersten Leuchtrichtung bereitzustellen, und das zweite Leuchtelement (12) dazu angeordnet ist, einen Lichtstrahl in einer zweiten Leuchtrichtung bereitzustellen;
einen Kühlkörper (2), der eine gebogene Kühlkörperplatte (102) umfasst, wobei die Kühlkörperplatte (102) einen ersten ebenen Abschnitt (21) und einen zweiten ebenen Abschnitt (22) aufweist, wobei das erste Leuchtelement (11) in direktem Kontakt mit dem ersten ebenen Abschnitt (21) und das zweite Leuchtelement (12) in direktem Kontakt mit dem zweiten ebenen Abschnitt (22) angeordnet ist,
**dadurch gekennzeichnet, dass**:
- die zweite Leuchtrichtung mindestens 20 Grad in Bezug auf die erste Leuchtrichtung bildet;
- der zweite ebene Abschnitt (22) in einer zweiten Ebene (20) enthalten ist, die den ersten ebenen Abschnitt (21) so schneidet, dass die zweite Ebene (20) und der Abschnitt des ersten ebenen Abschnitts (21), der in direktem Kontakt mit dem ersten Leuchtelement (11) steht, einen spitzen Winkel bilden;
- ein vorstehender Abschnitt (23) des ersten ebenen Abschnitts (21) und/oder ein vorstehender Abschnitt des zweiten ebenen Abschnitts (22) aus dem Kühlkörper (2) derart herausragt, dass der Kühlkörper Verbindungsarme (24) in direktem Kontakt mit dem ersten ebenen Abschnitt (21) und mit dem zweiten ebenen Abschnitt (22) aufweist, und
- jeder der Verbindungsarme (24) eine Krümmung definiert und die Differenz zwischen einer ersten Tangente (25), die die Krümmung in jedem ersten Punkt tangiert, und einer zweiten Tangente (26), die die Krümmung in jedem zweiten Punkt tangiert, kleiner als 90 Grad ist.

2. Automobilbeleuchtungsvorrichtung (1) gemäß Anspruch 1, wobei das Leuchtelement eine Festkörperlichtquelle ist, die direkt auf dem Kühlkörper montiert ist.

3. Automobilbeleuchtungsvorrichtung (1) gemäß Anspruch 1, wobei das Leuchtelement eine Leiterplatte ist, die Festkörperlichtquellen enthält.

4. Automobilbeleuchtungsvorrichtung (1) gemäß einem der vorhergehenden Ansprüche, wobei die Differenz zwischen einer ersten Tangente (25), die die Krümmung in einem beliebigen ersten Punkt tangiert, und einer zweiten Tangente (26), die die Krümmung in einem beliebigen zweiten Punkt tangiert, kleiner als 60 Grad ist.

5. Automobilbeleuchtungsvorrichtung (1) gemäß einem der vorhergehenden Ansprüche, ferner umfassend zusätzliche Wärmeabfuhrmittel in thermischem Kontakt mit dem Kühlkörper (2).

6. Automobilbeleuchtungsvorrichtung (1) gemäß Anspruch 5, wobei die zusätzlichen Wärmeabfuhrmittel Rippen (3) und/oder Stifte umfassen.

7. Automobilbeleuchtungsvorrichtung (1) gemäß einem der Ansprüche 5 oder 6, wobei die zusätzlichen Wärmeabfuhrmittel an den Kühlkörper (2) geklemmt sind.

8. Automobilbeleuchtungsvorrichtung (1) gemäß Anspruch 5, wobei die Kühlkörperplatte (102) einen gebogenen Abschnitt (27) aufweist, der die zusätzlichen Wärmeabfuhrmittel bildet.

9. Automobilbeleuchtungsvorrichtung (1) gemäß einem der vorhergehenden Ansprüche, ferner umfassend ein optisches Element (4), das dazu bestimmt ist, Licht aus dem ersten (11) und dem zweiten (12) Lichtquellenelement zu empfangen und das Licht außerhalb der Automobilbeleuchtungsvorrichtung (1) zu projizieren, wobei dieses optische Element beispielsweise eine Projektionslinse (4) ist.

10. Verfahren zum Herstellen einer Leuchtvorrichtung (1) gemäß einem der vorhergehenden Ansprüche,
**dadurch gekennzeichnet, dass** das Verfahren die Schritte umfasst:
Bereitstellen eines Kühlkörperblechs (102);
Ausführen mindestens eines Schnitts (103) im Kühlkörperblech (102), wobei der Schnitt zwei Verbindungsarme (24, 124), einen Verbindungsarm an jeder Seite eines ersten Abschnitts des Kühlkörperblechs, definiert;
Biegen der Verbindungsarme so, dass der erste Abschnitt (21) nicht gebogen wird und aus dem Kühlkörperblech herausragt;
erneutes Biegen der Verbindungsarme mit einem zweiten Abschnitt (22) des Kühlkörperblechs so, dass der zweite Abschnitt mindestens 20 Grad in Bezug auf den ersten Abschnitt bildet, wobei ein erstes Lichtquellenelement (11) im ersten Abschnitt des Kühlkörpers und ein zweites Lichtquellenelement (12) im zweiten Abschnitt des Kühlkörpers installiert wird.

11. Verfahren gemäß Anspruch 10, ferner umfassend die Schritte des Hinzufügens zusätzlicher Wärmeabfuhrmittel (3, 27).

12. Verfahren gemäß Anspruch 11, wobei die zusätzlichen Wärmeabfuhrmittel dem Kühlkörperblech durch Klemmen oder durch Fixieren hinzugefügt werden.

13. Verfahren gemäß Anspruch 11, wobei die zusätzlichen Wärmeabfuhrmittel (27) dem Kühlkörperblech durch Biegen mindestens eines Endes des Kühlkörperblechs hinzugefügt werden.

14. Verfahren gemäß einem der Ansprüche 10 bis 13, wobei das Kühlkörperblech (102) durch Kühlprägen gebildet wird und das Biegen durch Prägen erfolgt.

## Revendications

1. Dispositif d'éclairage automobile (1) comprenant au moins
un premier élément lumineux (11) pour une première fonctionnalité d'éclairage et un second élément lumineux (12) pour une seconde fonctionnalité d'éclairage, le premier élément lumineux (11) étant agencé pour fournir un faisceau lumineux dans une première direction de lumière et le second élément lumineux (12) étant agencé pour fournir un faisceau lumineux dans une seconde direction de lumière ;
un dissipateur thermique (2) comprenant une plaque de dissipateur thermique pliée (102), ladite plaque de dissipateur thermique (102) ayant une première partie plane (21) et une seconde partie plane (22), dans lequel le premier élément lumineux (11) est disposé en contact direct avec la première partie plane (21) et le second élément lumineux (12) est disposé en contact direct avec la seconde partie plane (22),
caractérisé en que :
- la deuxième direction de la lumière forme au moins 20 degrés par rapport à la première direction de la lumière ;
- la seconde partie plane (22) est contenue dans un second plan (20) qui coupe la première partie plane (21) de telle sorte que le second plan (20) et la partie de la première partie plane (21) qui est en contact direct avec le premier élément lumineux (11) forment un angle aigu ;
- une partie saillante (23) de la première partie plane (21) et/ou une partie saillante de la deuxième partie plane (22) fait saillie du dissipateur thermique (2) de telle sorte que le dissipateur thermique comprend des bras de connexion (24) en contact direct avec la première partie plane (21) et avec la deuxième partie plane (22), et
- chacun des bras de connexion (24) définit une courbe et la différence entre une première ligne tangente (25) qui est tangente à la courbe en tout premier point et une seconde ligne tangente (26) qui est tangente à la courbe en tout second point est inférieure à 90 degrés.

2. Dispositif d'éclairage automobile (1) selon la revendication 1, dans lequel l'élément lumineux est une source lumineuse à semi-conducteurs qui est directement montée sur le dissipateur thermique.

3. Dispositif d'éclairage automobile (1) selon la revendication 1, dans lequel l'élément lumineux est une carte de circuit imprimé qui contient des sources lumineuses à l'état solide.

4. Dispositif d'éclairage automobile (1) selon l'une quelconque des revendications précédentes, dans lequel la différence entre une première ligne tangente (25) qui est tangente à la courbe en tout premier point et une seconde ligne tangente (26) qui est tangente à la courbe en tout second point est inférieure à 60 degrés.

5. Dispositif d'éclairage automobile (1) selon l'une quelconque des revendications précédentes, comprenant en outre des moyens supplémentaires de dissipation de chaleur en contact thermique avec le dissipateur thermique (2).

6. Dispositif d'éclairage automobile (1) selon la revendication 5, dans lequel les moyens de dissipation de chaleur supplémentaires comprennent des ailettes (3) et/ou des broches.

7. Dispositif d'éclairage automobile (1) selon l'une quelconque des revendications 5 ou 6, dans lequel les moyens supplémentaires de dissipation de chaleur sont serrés sur le dissipateur thermique (2).

8. Dispositif d'éclairage automobile (1) selon la revendication 5, dans lequel la plaque de dissipation thermique (102) comprend une partie pliée (27) qui forme le moyen de dissipation thermique supplémentaire.

9. Dispositif d'éclairage automobile (1) selon l'une quelconque des revendications précédentes, comprenant en outre un élément optique (4) destiné à recevoir de la lumière en provenance des premier (11) et deuxième (12) éléments sources de lumière, et à projeter la lumière à l'extérieur du dispositif d'éclairage automobile (1), cet élément optique étant par exemple une lentille de projection (4).

10. Procédé de fabrication d'un dispositif d'éclairage (1) selon l'une quelconque des revendications précédentes, **caractérisé en ce que** le procédé comprend les étapes de fournir une plaque de dissipation thermique (102)
réaliser au moins une découpe (103) dans la plaque de dissipateur thermique (102), la découpe définissant deux bras de connexion (24, 124), un bras de connexion de chaque côté d'une première partie de la plaque de dissipateur thermique ;
plier les bras de connexion de sorte que la première partie (21) ne soit pas pliée et fasse saillie de la plaque de dissipation thermique ;
plier à nouveau les bras de liaison avec une deuxième partie (22) de la plaque de dissipation thermique, de sorte que la deuxième partie forme au moins 20 degrés par rapport à la première partie
installer un premier élément de source de lumière (11) dans la première partie du dissipateur thermique et un second élément de source de lumière (12) dans la seconde partie du dissipateur thermique.

11. Procédé selon la revendication 10, comprenant en outre les étapes consistant à ajouter des moyens de dissipation de chaleur supplémentaires (3, 27).

12. Procédé selon la revendication 11, dans lequel les moyens de dissipation thermique supplémentaires sont ajoutés à la plaque de dissipation thermique par serrage ou par fixation.

13. Procédé selon la revendication 11, dans lequel les moyens de dissipation de chaleur supplémentaires (27) sont ajoutés au dissipateur thermique en pliant au moins une extrémité de la plaque du dissipateur thermique.

14. Procédé selon l'une quelconque des revendications 10 à 13, dans lequel la plaque de dissipation thermique (102) est formée par emboutissage à froid, le pliage étant réalisé par emboutissage.
